# EUROPEAN PATENT APPLICATION

(11) **EP 4 485 538 A1**
(43) Date of publication of application: **01.01.2025**
(21) Application number: 23213940.2
(22) Date of filing: 04.12.2023
(51) Int. Cl.: H01L 29/04, H01L 29/165, H01L 29/417, H01L 29/66, H01L 29/775, H01L 29/78, H01L 29/08, H01L 29/786

(54) **HIGH CONDUCTIVITY TRANSISTOR CONTACTS COMPRISING GALLIUM ENRICHED LAYER**

(30) Priority: 30.06.2023 US 202318346087
(71) Applicant: Intel Corporation, Santa Clara, CA 95054 (US)
(72) Inventor: Murthy, Anand, Portland, 97229 (US); Badmaev, Alexander, Portland, 97229 (US); Chen, Zhiyi, Portland, 97229 (US); Nandi, Debaleena, Hillsboro, 97124 (US); Ghani, Tahir, Portland, 97229 (US)
(74) Representative: Goddar, Heinz J.

(57) **Abstract**

In some implementations, an apparatus may include a substrate (218) having silicon. In addition, the apparatus may include a first layer of a source or drain region (225) of a p-type transistor, the first layer positioned above the substrate, the first layer having boron, silicon and germanium. The apparatus may include a second layer (217) coupled to the source or drain region, the second layer having a metal contact for the source or drain region. Moreover, the apparatus may include a third layer (219) positioned between the first layer and the second layer, the third layer having at least one monolayer having gallium, where the third layer is adjacent to the first layer.

## Description

### BACKGROUND

Contact resistance (e.g., at the interface between a source material and a source contact metal as well as between a drain material and a drain contact metal) plays a crucial role in transistor applications. This resistance directly impacts the performance of the transistor and determines the maximum clock frequency achievable in devices utilizing these transistors.

### BRIEF DESCRIPTION OF DRAWINGS

FIG. 1A is a perspective view of an example planar field effect transistor (FET) comprising a gate, a source region, and a drain region.
FIG. 1B is a cross-sectional view of the planar FET taken along the source contact region of transistor.
FIG. 2A is a perspective view of an example FinFET comprising a gate, a source region, a drain region, and a fin.
FIG. 2B is a cross-sectional view of the example FinFET taken along the source region.
FIG. 2C illustrates a cross-section of a variation of the FinFET in which the source contact metal is located on only a portion of the outer surfaces of the source semiconductor layer.
FIG. 3A is a perspective view of a gate-all-around FET (GAAFET) comprising a gate, a source region, a drain region and a semiconductor layer.
FIG. 3B is a cross-sectional view of the GAAFET taken along the source contact region.
FIG. 3C shows a cross-section of a version of the GAAFET in which the width and thickness of the semiconductor layer are similar.
FIG. 4A is a perspective view of a stacked GAAFET.
FIG. 4B is a cross-sectional view of the example stacked GAAFET taken along the source contact region.
FIG. 4C shows a cross-section of a version of the GAAFET in which the width and thickness of the semiconductor layers are similar.
FIG. 5 illustrates a portion of an example integrated circuit.
FIG. 6 depicts a portion of an example P-type metal-oxide-semiconductor (PMOS) source/drain region.
FIG. 7 illustrates Secondary Ion Mass Spectrometry (SIMS) profiles of different source/drain compositions.
FIG. 8 illustrates an example method for forming high conductivity p-type transistor contacts comprising gallium enriched layer adjacent to boron doped silicon germanium epitaxial film.
FIG. 9 provides a schematic illustration of a cross-sectional view of an example integrated circuit device.
FIG. 10 is a top view of an example wafer and dies that may be included in a microelectronic assembly.
FIG. 11 is a cross-sectional side view of an example integrated circuit device.
FIGS. 12A-12D are simplified perspective views of example planar, FinFET, gate-all-around, and stacked gate-all-around transistors.
FIG. 13 is a cross-sectional side view of an example integrated circuit device assembly.
FIG. 14 is a block diagram of an example electrical device.

### DETAILED DESCRIPTION

As transistors scale to smaller dimensions, maintaining a suitable contact resistivity of a source/drain (where "source/drain" may refer to either or both of a source or drain of a transistor) becomes a challenge. For example, contact resistivity of less than 1E-09 Ohms-cm² may be desirable to achieve suitable operation. Contact resistivity may be lowered by reducing the Schottky barrier height (SBH) between a contact metal and a silicide formed on the edge of a source/drain material (e.g., by increasing the germanium concentration in a portion of the source/drain to 60-80% in a source/drain comprising boron doped silicon germanium (B:SiGe)). The silicide may be formed with boron doped silicon germanium, where boron is incorporated during epitaxial deposition and/or with boron-11 implants. Contact resistivity may also be lowered by increasing the electrically active boron concentration in a portion of the source/drain to 2E21 atoms/cm³ (e.g., by utilizing non-equilibrium low temperature B:SiGe epitaxial deposition). However, such techniques may not be sufficient to reduce the contact resistivity to a desired level (e.g., such techniques may only reduce the resistivity in certain architectures to ~1.5E-9 Ohms-cm²). Thus, contact resistivity may be limited when a single active dopant (e.g., boron) is present at the silicide interface of the source/drain.

In various embodiments, the contact resistivity of a PMOS source/drain is reduced through the incorporation of a gallium enriched layer between a source/drain material (e.g., boron doped silicon germanium) and a source/drain contact metal (e.g., at the silicide interface of the source/drain). In various embodiments of the present disclosure, epitaxially grown B:SiGe of a source/drain is exposed insitu to a metallo-organic precursor containing gallium. For example, the precursor may comprise triethyl gallium or trimethyl gallium. In various embodiments, in the gallium enriched layer (e.g., at the top or other outer surface of the B:SiGe, such as within the first five nanometers of depth of this surface or within the first two monolayers of the layer), the gallium may be incorporated in the range of 5E19 to 5E20 atoms/cm³. Incorporation of the gallium will increase the total carrier concentration (e.g., of boron and gallium atoms) at the contact surface of the source/drain (e.g., where the source/drain material couples to the contact metal), thus reducing the contact resistivity (e.g., to below 1E-9 Ohms-cm² in some embodiments).

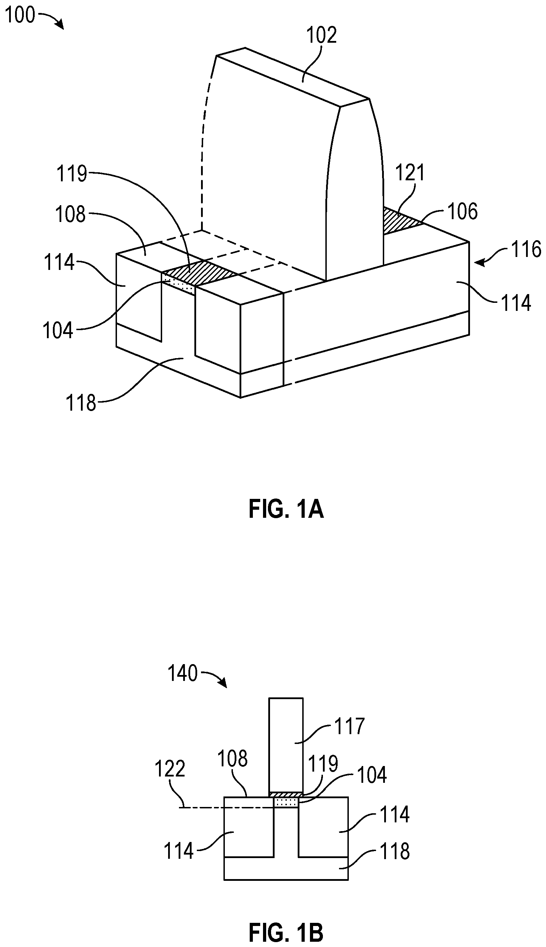

FIG. 1A is a perspective view of an example planar field effect transistor (FET) 100 comprising a gate 102, a source region 104, and a drain region 106. The planar FET 100 is formed on a substrate 116 comprising a surface 108, a bulk region 118, and isolation regions 114 that separate the source and drain regions 104 and 106 from other transistors. A gallium enriched layer 119 is positioned between the source region 104 and a source contact metal 117 (shown in FIG. 1B) and a gallium enriched layer 121 is positioned between the drain region 106 and a drain contact metal (not shown). The planar FET 100 is planar in that the source region 104 and the drain region 106 are planar with respect to the surface 108 of the substrate 116. FIG. 1B is a cross-sectional view 140 of the planar FET 100 taken along the source contact region of planar FET 100. Cross-sectional view 140 illustrates a source contact metal 117 located above the source region 104, with the gallium enriched layer 119 positioned between the source contact metal 117 and the source region 104. The source region 104 extends from the surface 108 of the substrate 116 to a depth 122 within the substrate 116.

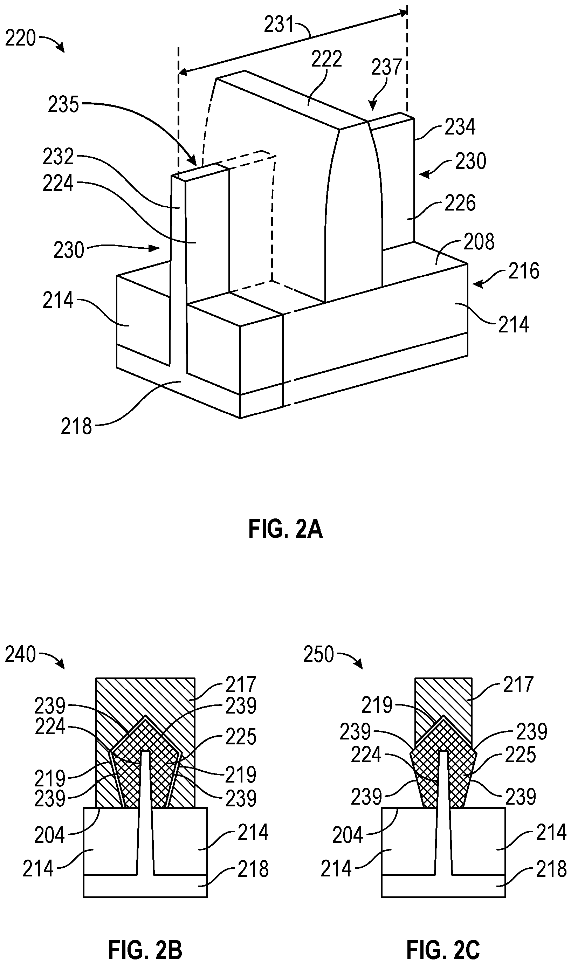

FIG. 2A is a perspective view of an example FinFET 220 comprising a gate 222, a source region 235, a drain region 237, and a fin 230. FIG. 2B is a cross-sectional view of the example FinFET 200 taken along the source region 235. The FinFET 220 is formed on a substrate 216 comprising a surface 208, a bulk region 218, and isolation regions 214 that separate the source and drain regions 235 and 237 from other transistors. The fin 230 extends from the surface 208 of the substrate 216 and extends along a length 231 from a first end 232 of the fin 230 to a second end 234 of the fin 230. The gate 222 controls the flow of current from a source portion 224 of the fin 230 to a drain portion 226 of the fin 230. The channel region of the FinFET 220 is formed by the portion of the fin 230 encompassed by the gate 222.

The source region 235 comprises the source portion 224 of the fin 230 and a source semiconductor layer 225 (not shown in FIG. 2A) that is positioned adjacent to and encompasses at least a portion of the length 231 of the fin 230 (e.g., the source portion 224 of the fin 230). The source semiconductor layer 225 comprises one or more outer surfaces 239 (the surfaces of the source semiconductor layer 225 not positioned adjacent to the surface 208 of the substrate 216). A source contact metal 217 is located on at least a portion of the outer surfaces 239 along at least a portion of a length of the source semiconductor layer 225. A gallium enriched layer 219 is positioned between the source semiconductor layer 225 and the source contact metal 217. The length 231 of the fin 230 and the length of the source semiconductor layer 225 extend in a same direction that is parallel to the surface 208 of the substrate 216.

The drain region 237 comprises a drain portion 226 of the fin 230 and a drain semiconductor layer (not shown) that is positioned adjacent to and encompasses at least a portion of the length 231 of the fin 230 (the drain portion of the fin 230). Similar to the source semiconductor layer, the drain semiconductor layer comprises one or more outer surfaces not positioned adjacent to the surface 208 of the substrate 216. A drain contact layer (not shown in FIG. 2A) is located on at least a portion of the outer surfaces of the drain semiconductor layer along at least a portion of a length of the drain semiconductor region. A gallium enriched layer (not shown) is positioned between the drain semiconductor layer and the drain contact metal. The length 231 of the fin 230 and the length of the drain semiconductor layer extend in a same direction that is parallel to the surface 208 of the substrate 216. The drain semiconductor layer, drain contact metal, and the gallium enriched layer between the drain contact layer and the drain contact metal of the FinFET 220 are not shown in FIGS. 2A-2C but are similar to their illustrated source counterparts (source semiconductor layer 225, source contact metal 217, gallium enriched layer 219).

The FinFET 220 is non-planar in that the fin 230 extends from the surface 208 of the substrate 216. As the gate 222 encompasses three sides of the fin 230, the FinFET 220 can be considered a tri-gate transistor. FIG. 2A illustrates one fin extending through the gate 222, but in other embodiments multiple fins can extend through the gate of a FinFET transistor.

FIG. 2B is a cross-sectional view of the example FinFET 200 taken along the source region 235. Cross-section 240 illustrates the source contact metal 217 located around the source semiconductor layer 225, with the gallium enriched layer 219 positioned between the source contact metal 217 and the source semiconductor layer 225.As can be seen in FIG. 2B, the source contact metal 217 encompasses the outer surfaces 239. In such embodiments, the contact can be referred to as a wrap-around contact.

FIG. 2C illustrates a cross-section 250 of a variation of the FinFET 220 in which the source contact metal 217 is located above only a portion of the outer surfaces 239 of the source semiconductor layer 225. In cross-section 250, the source contact metal 217 is generally located above the upper outer surfaces (e.g., only two outer surfaces 239) of the source semiconductor layer 225 and the gallium enriched layer 219 is positioned adjacent to only the outer surfaces on which the source contact metal 217 is located. Although the extent of the gallium enriched layer 219 illustrated in FIG. 2C is shown as being substantially aligned with that of the source contact metal 217, in other embodiments, the gallium enriched layer 219 can extend further than the extent of the source contact metal 217 in a non-wrap-around-contact. For example, in some embodiments, the gallium enriched layer 219 of FIG. 2C can encompass all of the outer surfaces 239 of the source semiconductor layer 225, as shown in FIG. 2B.

Although source semiconductor layer 225 is illustrated as having a pentagonal cross-sectional shape in FIGS. 2B-2C, the shape of source and drain semiconductor layers in FinFET contacts are not limited as such. In other embodiments, the cross-sectional shape of source and drain semiconductor regions in FinFET contacts can have a shape different from that illustrated in FIGS. 2B-2C.

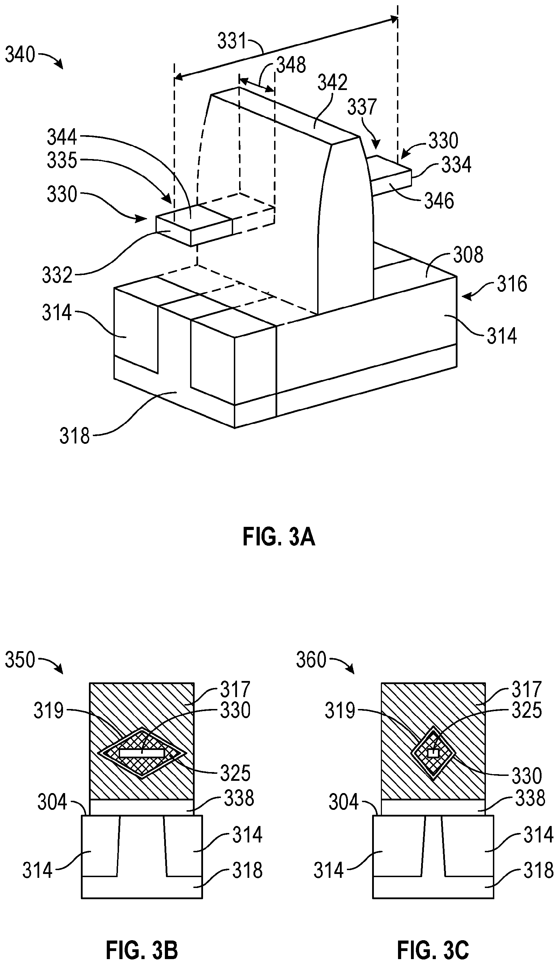

FIG. 3A is a perspective view of a gate-all-around FET (GAAFET) 340 comprising a gate 342, a source region 335, a drain region 337 and a semiconductor layer 330. The GAAFET 340 is formed on a substrate 316 comprising a surface 308, a bulk region 318, and isolation regions 314. The semiconductor layer 330 is located above and separate from the substrate 316 and is substantially parallel to the surface 308 of the substrate 316. The semiconductor layer 330 extends from a first end 332 of the semiconductor layer 330 to a second end 334 of the semiconductor layer. The gate 342 controls the flow of current through a channel region from the source portion 344 of the semiconductor layer 330 to a drain portion 346 of the semiconductor layer 330. The channel region is created by the gate 342 encompassing a portion of the semiconductor layer 330.

The source region 335 comprises the source portion 344 of the semiconductor layer 330 and a source semiconductor layer 325 (not shown in FIG. 3A) positioned adjacent to and encompassing at least a portion of the length 331 of the semiconductor layer 330 (the source portion 344 of the semiconductor layer 300). A source contact metal 317 (not shown in FIG. 3A) encompasses the source semiconductor layer 325 along at least a portion of a length of the source semiconductor layer 325. A gallium enriched layer 319 is positioned between the source semiconductor layer 325 and the source contact metal 317. The length 331 of the semiconductor layer 330 and the length of the source semiconductor layer 325 extend in a same direction that is parallel to the surface 308 of the substrate 316.

The drain region 337 comprises a drain portion 346 of the semiconductor layer 330 and a drain semiconductor layer positioned adjacent to and encompassing at least a portion of the length 331 of the semiconductor layer 330 (the drain portion 346 of the semiconductor layer 300). A drain contact metal encompasses the drain semiconductor layer along at least a portion of a length of the drain semiconductor layer. A gallium enriched layer is positioned between the drain semiconductor layer and the drain contact metal. The drain semiconductor layer, drain contact metal, and the gallium enriched layer between the drain semiconductor layer and the drain contact metal of the GAAFET 340 are not shown in FIGS. 3A-3C, but are similar to their illustrated source counterparts (source semiconductor layer 325, source contact metal 317, gallium enriched layer 319).

A source isolation region 338 is positioned between the source contact metal 317 and the substrate 316 to isolate the source contact metal 317 from the substrate 316 and a drain isolation region (not shown) is positioned between the drain contact metal and the substrate 316 to isolate the drain contact metal from the substrate.

The GAAFET 340 is non-planar in that the semiconductor layer 330 is located above and is separate from the substrate 316. The GAAFET 340 is considered a gate-all-around transistor as the gate 342 encompasses all four sides of the semiconductor layer 330 along the portion of the length 331 of the semiconductor layer 330. FIG. 3B is a cross-sectional view of the GAAFET 340 taken along the source contact region. Cross-section 350 illustrates the gallium enriched layer 319 positioned between the source contact metal 317 and the source semiconductor layer 325.

The GAAFET 340 can be alternatively referred to as a nanowire or a nanoribbon transistor, depending on a width 348 of the semiconductor layer 330 extending through the gate 342 relative to the thickness of the semiconductor layer 330. As the width 348 of the semiconductor layer 330 in FIG. 3B is greater than the thickness of the semiconductor layer 330, the GAAFET 340 can be referred to as a nanowire transistor. FIG. 3C shows a cross-section 360 of a version of the GAAFET 340 in which the width and thickness of the semiconductor layer 330 are similar. Accordingly, the version of the GAAFET 340 having the cross-section 360 can be referred to as a nanowire transistor.

Although source semiconductor layer 325 is illustrated as having a diamond cross-sectional shape in FIGS. 3A-3B the shape of source and drain semiconductor layers in GAAFET contacts are not limited to such. In other embodiments, the cross-section of source and drain regions semiconductor layers in GAAFET contacts can have a shape different from that illustrated in FIGS. 3B-3C.

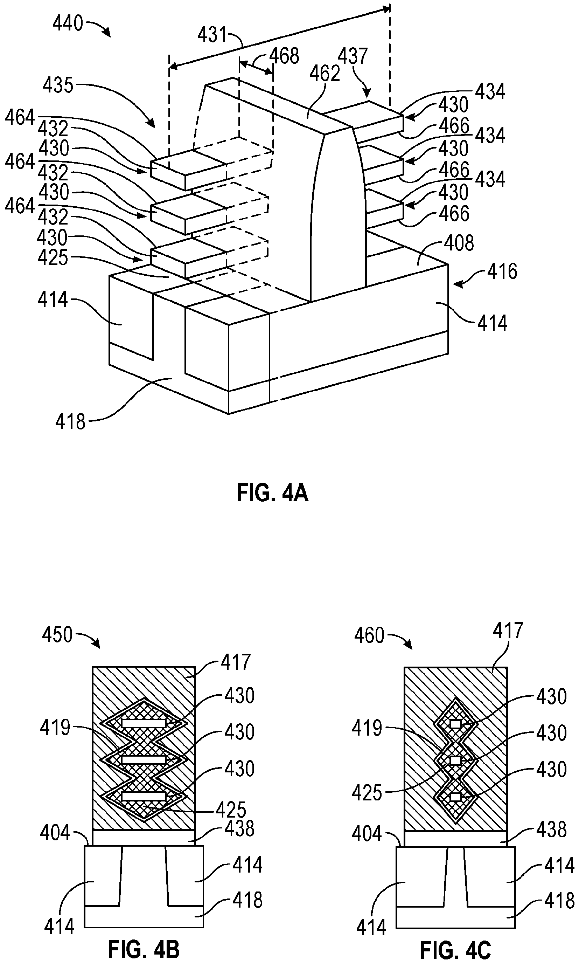

FIG. 4A is a perspective view of a stacked GAAFET 440. The stacked GAAFET 440 is similar to the GAAFET 340 of FIG. 3A but with multiple semiconductor layers 430 located above the substrate. The stacked GAAFET 440 is formed on a substrate 416 comprising a surface 408, a bulk region 418, and isolation regions 414. The stacked GAAFET 440 comprises a gate 462, a source region 435, and a drain region 437 and multiple semiconductor layers 430. The individual semiconductor layers 430 are substantially parallel to the surface 408 of the substrate 416 and extend along a length 431 from a first end 432 of the individual semiconductor layer 430 to a second end 434 of the individual semiconductor layer 430. The semiconductor layers 430 are stacked vertically with respect to the surface 408 of the substrate 416. The gate 442 controls the flow of current through multiple channel regions from source portions 464 of the semiconductor layers 430 to drain portions 466 of the semiconductor layers 430. The channel regions are formed by the gate 442 encompassing a portion of the semiconductor layers 430.

The source region 435 comprises the source portions 464 of the semiconductor layers 430 and a source semiconductor layer 425 is positioned adjacent to and encompasses at least a portion of the length 431 of the individual semiconductor layers 430 (the source portions 464 of the semiconductor layers 430). A source contact metal 417 encompasses the source semiconductor layer 425 along at least a portion of a length of the source semiconductor layer 425. A gallium enriched layer 419 is positioned between the source semiconductor layer 425 and the source contact metal 417. The length 431 of the semiconductor layers 430 and the length of the source semiconductor layer 425 extend in a same direction that is parallel to the surface 408 of the substrate 416.

The drain region 437 comprises drain portions 466 of the semiconductor layers 430 and a drain semiconductor layer is positioned adjacent to and encompasses at least a portion of the length 431 of the individual semiconductor layers 430 (the drain portions 466 of the semiconductor layers 430). A drain contact metal encompasses the drain semiconductor layer along at least a portion of the length of the drain semiconductor layer. A gallium enriched layer is positioned between the drain semiconductor layer and the drain contact metal. The drain semiconductor layer, drain contact metal, and the gallium enriched layer between the drain contact layer and the drain contact metal of the stacked GAAFET 440 are not shown in FIG. 4A but are similar to their illustrated source counterparts (source semiconductor layer 425, source contact metal 417, gallium enriched layer 419). The length 431 of the semiconductor layers 430 and the length of the drain semiconductor layer extend in a same direction that is parallel to the surface 408 of the substrate 416.

FIG. 4B is a cross-sectional view of the example stacked GAAFET 440 taken along the source contact region. Cross-section 450 illustrates the gallium enriched layer 419 positioned between the source contact metal 417 and the source semiconductor layer 425. FIG. 4C shows a cross-section 460 of a version of the GAAFET 440 in which the width (e.g., width 468) and thickness of the semiconductor layers 430 are similar. Accordingly, the version of the GAAFET 440 having the cross-section 460 can be referred to as a nanowire transistor.

Although source semiconductor layer 425 is illustrated as having a stacked diamond cross-sectional shape in FIGS. 4B-4C, the shape of source and drain semiconductor regions in a stacked GAAFET are not limited as such. In other embodiments, the cross-sectional shape of source and drain semiconductor layers in a stacked GAAFET can have a shape different than that illustrated in FIGS. 4B-4C.

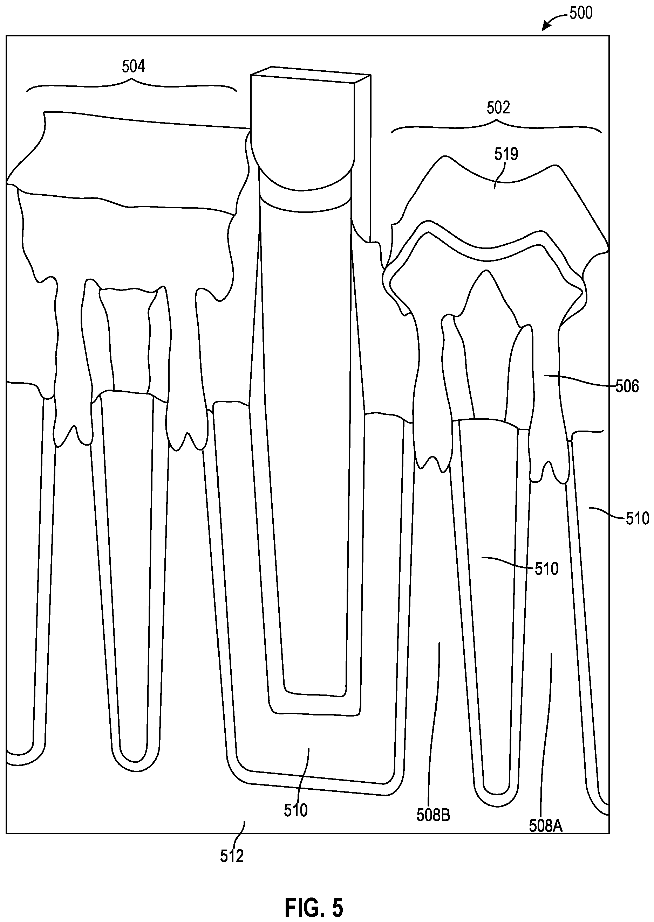

FIG. 5 illustrates a portion of an example integrated circuit 500. Integrated circuit 500 represents an alternative FinFET architecture and comprises a p-channel metal-oxide semiconductor (PMOS) source/drain region 502 and an n-channel metal-oxide semiconductor (NMOS) source/drain region 504 on a substrate 512.

Various characteristics described below in connection with source/drain semiconductor layers 506 and gallium enriched layer 519 may apply to the other source/drain semiconductor layers and gallium enriched layers described above or to such layers in alternative architectures.

The source/drain region 502 comprises a source/drain semiconductor layer 506 that is coupled to subfins 508A and 508B. The subfins 508 may comprise the same material as the substrate (e.g., a semiconductor material, such as silicon). The subfins 508 may be separated from each other by a dielectric, such as an isolation oxide 510.

The source/drain semiconductor layer 506 of the source/drain region 502 may be formed (e.g., within a trench formed in an insulating oxide) by depositing a source/drain material (e.g., boron doped silicon germanium). In various embodiments, the source/drain semiconductor layer 506 may be epitaxially grown using any suitable deposition process (e.g., chemical vapor deposition).

In some embodiments, a thin additional layer (e.g., 10-20 nanometers thick) of boron doped silicon germanium is then epitaxially deposited on the outer (e.g., top) surface of the source/drain semiconductor layer 506. In various embodiments, the boron is not supplied by implants but rather is in-situ doped. Accordingly, the source/drain semiconductor layer 506 may include both B-11 and B-10 isotopes (epitaxially deposited Ge:B results in both B-11 and B-10 isotopes, whereas germanium implanted with boron results in only B-11 isotopes and no appreciable B-10 isotopes). In various embodiments, the boron doped silicon germanium may be deposited at a relatively low temperature, e.g., in the range of 350 to 475 degrees Celsius (e.g., at approximately 375 degrees Celsius). This temperature may be lower than the temperature used to form the source/drain semiconductor layer 506.

This deposition may result in a high amount of electrically active boron (e.g., in excess of 2E21 atoms/cm³) at the surface of the source/drain region 502 that is to interface with the source/drain contact metal, thus resulting in a reduction of the Schottky barrier height. The amount of chemically incorporated boron may be higher (e.g., up to 3e21 atoms/cm³) than the amount of electrically active boron, as it may include the total amount of boron incorporated into the silicon germanium lattice, including boron incorporated in substitutional lattice sites, interstitial sites, clustered, and so on, while only boron present at substitutional sites of the silicon germanium lattice is electrically active.

In various embodiments, the thin layer (e.g., which corresponds to the gallium enriched layer 519) may have a higher concentration of germanium (e.g., 60-80 atomic percent) than the source-drain semiconductor layer 506 (e.g., 45-55 atomic percent). The higher germanium concentration may reduce the SBH, resulting in reduced contact resistivity. The higher germanium concentration may also facilitate increased incorporation of electrically active boron concentration in the thin layer (an important characteristic at the surface of the source/drain), thus improving the resistivity.

The formation of the thin layer may result in the formation of an interface between the thin layer and the source/drain semiconductor layer 506. This interface may include some trace contaminants (e.g., one or more of oxygen, carbon, fluorine, chlorine, or other contaminants). The interface may additionally or alternatively also include some breaks in the lattice continuity.

In various embodiments, the thin layer may be grown with high selectivity. For example, the film of the thin layer is only grown on the source/drain semiconductor layer 506 and is not grown on dielectric surfaces (e.g., comprising oxides, nitrides, oxynitrides, etc.), such as spacers, hard masks, isolation regions, etc. In order to achieve this selectivity, the precursor chemistry may be different from the precursor chemistry used to form the source/drain semiconductor layer 506. In various embodiments, germanium tetrachloride is used as a precursor during the formation of the thin layer and/or hydrogen chloride (in a gas phase) is used as a precursor during the formation of the source/drain semiconductor layer 506. In some embodiments, the precursor used for the source/drain semiconductor layer 506 (e.g., hydrogen chloride) would not be effective at the reduced temperature used during formation of the thin layer. In various embodiments, a different pressure may also be used for formation of the thin layer relative to the pressure used to form the source/drain semiconductor layer 506.

In some embodiments, gallium may be incorporated as part of the growth of the thin layer to form the gallium enriched layer 519 (e.g., a gas comprising gallium may be included in the flow of the other materials applied during formation of the thin layer). In other embodiments, the gallium may be applied in situ to the thin layer after the thin layer is formed to form the gallium enriched layer 519.

In various embodiments, the newly formed thin layer is treated with a precursor comprising gallium (e.g., triethyl gallium, trimethyl gallium, or other gas comprising gallium) for a period of time (e.g., an amount of time between 10 seconds and 10 minutes, in one embodiment approximately 2 minutes) to form gallium enriched layer 519. The gallium may be applied, e.g., at a temperature of between 375 and 500 degrees Celsius. In one embodiment, the gallium is applied at approximately 450 degrees Celsius. In various embodiments, the gallium is applied using chemical vapor deposition (CVD) without directionality (or other suitable deposition technique).

The application of the precursor results in gallium being incorporated in the top few monolayers of the thin layer, thus forming the gallium enriched layer 519. For example, gallium may be included in the top monolayer or the top two monolayers and no appreciable amount of gallium is included in the monolayers of the source/drain region 502 that are below the top two monolayers (or at least much less gallium is included in the monolayers below the top two monolayers than within the top two monolayers). For example, any monolayer below the top two monolayers may comprise less than 5 atomic percent of gallium and in some embodiments less than 1 atomic percent. In some embodiments, the top two monolayers may include gallium with an atomic percent within the range of 5%-20%, while the atomic percent of gallium drops to approximately 1% or lower past 5 nanometers from the surface. In various embodiments, the atomic % of gallium in the thin layer may be less than 5%, less than 3%, or less than 1% past the first two monolayers of the gallium enriched layer. In various embodiments, the gallium may be incorporated into substitutional sites of a silicon or silicon germanium lattice, thus rendering it electrically active.

In some embodiments, the application of the gallium is graded, such that the gallium concentration is highest at the outer surface of the gallium enriched layer 519. This may be accomplished by starting the flow of the gallium precursor at a relatively low level and increasing the flow over time as the gallium is applied.

In various embodiments, the gallium enriched layer 519 may have a resistivity (e.g., .15-.25 milliohms-cm) that is lower than the resistivity (e.g., .3 to .5 milliohms-cm) of the source/drain semiconductor layer 506.

In various embodiments, the gallium is deposited only over the source/drains of the PMOS devices of the integrated circuit 500, and not the source/drains of the NMOS devices. For example, the NMOS regions may be covered with a hard mask/dielectric layer prior to deposition of the gallium.

A drain/source contact metal (not shown) may be formed over the gallium enriched layer 519. In some embodiments, one or more intermediate contact materials may be formed between the gallium enriched layer 519 and the drain/source contact metal. The intermediate contact material may comprise one or more conductive materials, such as titanium, nickel, or platinum. In various embodiments, an intermediate contact material may interact with silicon of the drain/source semiconductor layer 506 to form a silicide (e.g., at the top surface). In one embodiment, titanium is deposited on the gallium, resulting in formation of titanium germanium silicide. In various embodiments, a thin metal nitride (e.g., titanium nitride) may also (or alternatively) be deposited as an intermediate contact material. The source/drain contact metal (e.g., tungsten, cobalt, copper, aluminum, ruthenium, alloys of any of these, or other conductive material) may then be formed over the intermediate contact material.

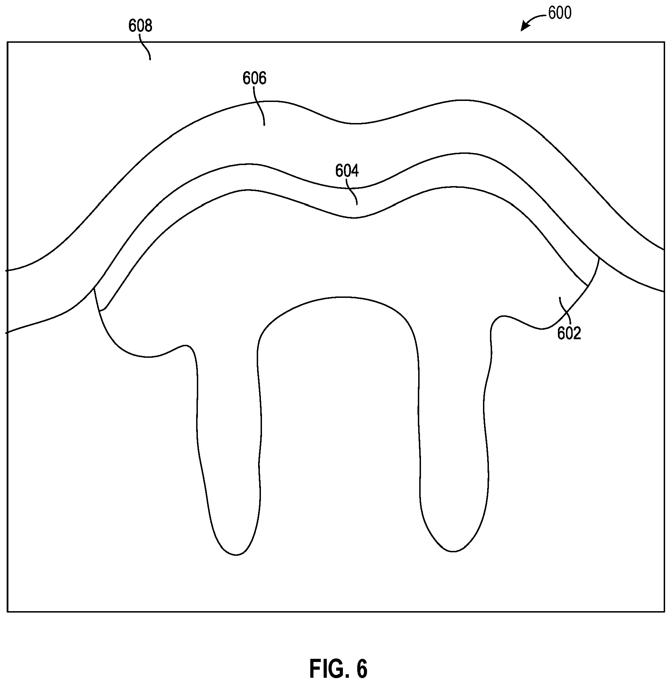

FIG. 6 depicts a portion of an example PMOS source/drain region 600. The source/drain region 600 illustrates a FinFET architecture and comprises a source/drain semiconductor layer 602 (e.g., comprising boron doped silicon germanium), a gallium enriched layer 604, an intermediate contact layer 606 (e.g., comprising titanium), and a source/drain contact metal 608 (e.g., comprising tungsten).

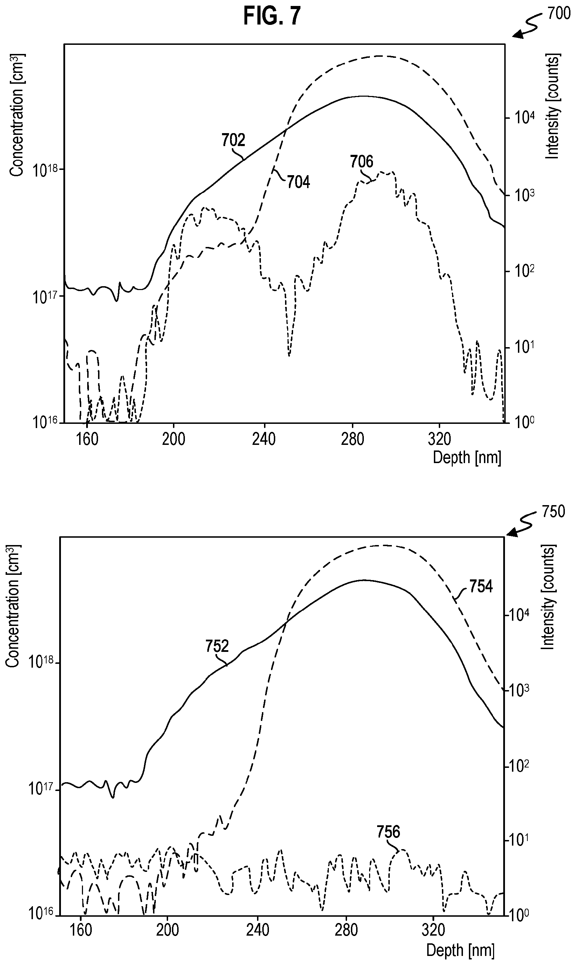

FIG. 7 illustrates Secondary Ion Mass Spectrometry (SIMS) profiles of different source/drain compositions. Graph 700 illustrates a profile of an example source/drain with a gallium enriched selective insitu boron doped silicon germanium epitaxial film while graph 750 illustrates a profile of an example source/drain with boron doped silicon germanium epitaxial film that is not enriched with gallium.

Waveforms 702 and 752 depict the respective concentrations of boron, waveforms 704 and 754 depict the respective concentrations of germanium, and waveforms 706 and 756 depict the respective concentrations of gallium (all as a function of depth into the epitaxial of the source/drain). As depicted, the gallium concentration depicted in the first graph 700 is noticeably higher at various depths relative to the gallium depicted in the second graph 750.

The embodiments described (e.g., utilizing a gallium enriched layer between a source contact metal and a source/drain semiconductor layer) herein may be utilized for many different types of transistors, including at least planar transistors, FinFETs, GAAFETs, channel FETs, stacked complementary metal-oxide-semiconductor (CMOS) transistors, complementary FETs (C-FETs), nanowires/ribbons, stacked nanowires/ribbons, tunnel FETs, or other suitable transistors comprising source/drains. Any suitable embodiments described herein may also be used for transistors with the entire source/drain deposited during trench contact (TCN) etch out, process flows of gate first or gate last, transistors where backend contacts are made from the backside of the wafer through via, and transistors made on the backside of the wafer.

Any suitable channel material may be used in a transistor implementing any of the various embodiments described above. For example, the channel material may comprise silicon, strained silicon, relaxed or strained silicon germanium, silicon germanium tin, germanium tin, or III-Vs.

Moreover, any suitable characteristics of particular components (e.g., gallium enriched layers, source/drain regions, source/drain semiconductor layers, source/drain contact metals, etc.) described with respect to one of the embodiments herein may also be applicable to the other embodiments described herein. As just one example, the method of forming or other characteristics of the gallium enriched layer 519 may apply to the other gallium enriched layers (e.g., 119, 219, 319, 419, etc.) described herein.

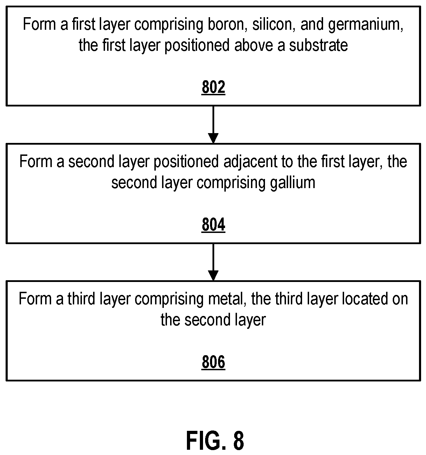

FIG. 8 illustrates an example method for forming high conductivity p-type transistor contacts comprising gallium enriched layer adjacent to boron doped silicon germanium epitaxial film.

At 802, a first layer comprising boron, silicon, and germanium is formed. The first layer is positioned above a substrate. For example, the first layer may be formed on the substrate (e.g., on a surface of the substrate and/or on a fin extending from the substrate).

At 804, a second layer positioned adjacent to the first layer is formed. The second layer comprises gallium.

At 806, a third layer comprising metal is formed on the second layer.

Although FIG. 8 shows example blocks of process 800, in some implementations, process 800 may include additional blocks, fewer blocks, different blocks, or differently arranged blocks than those depicted in Fig. 8. Additionally, or alternatively, two or more of the blocks of process 800 may be performed in parallel.

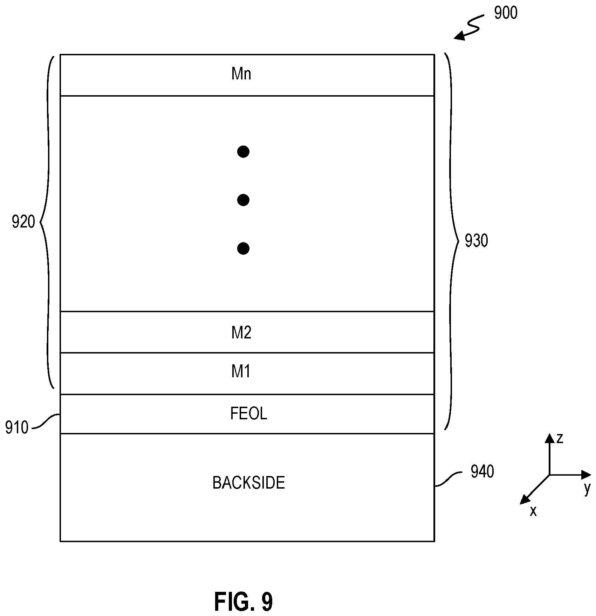

FIG. 9 provides a schematic illustration of a cross-sectional view of an example integrated circuit device (e.g., a chip) 900, according to some embodiments of the present disclosure. The IC device 900 may include one or more transistors comprising a gallium enriched layer as described herein.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL may include contacts, insulating layers (dielectrics), metal levels, and bonding sites for chip-to-package connections. In the BEOL part of the fabrication stage contacts (pads), interconnect wires, vias and dielectric structures are formed.

Embodiments described herein may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

As shown in FIG. 9, the IC device 900 may include a front side 930 comprising a FEOL portion 910 that includes various logic layers, circuits, and devices to drive and control a logic IC. These circuits and devices may be configured for any number of functions, such as logic or compute transistors, input/output (I/O) transistors, access or switching transistors, and/or radio frequency (RF) transistors, to name a few examples. According to some embodiments, in addition to these devices and circuits, FEOL portion 910 may include, for example, one or more other layers or structures associated with the semiconductor devices and circuits. For example, the FEOL portion 910 can also include a substrate and one or more dielectric layers that surround active and/or conductive portions of the devices and circuits. The FEOL portion may also include one or more conductive contacts that provide electrical contact to transistor elements such as gate structures, drain regions, or source regions. The FEOL portion may also include local interconnect (e.g., vias or lines) that connect contacts to interconnect features within the BEOL portion 920.

The front side 930 of the IC device 900 also includes a BEOL portion 920 including various metal interconnect layers (e.g., metal 9 through metal n, where n is any suitable integer). Various metal layers of the BEOL portion 920 may be used to interconnect the various inputs and outputs of the FEOL portion 910.

Generally speaking, each of the metal layers of the BEOL portion 920, e.g., each of the layers M1-Mn shown in FIG. 9, may include a via portion and a trench/interconnect portion. Typically, the trench portion of a metal layer is above the via portion, but, in other embodiments, a trench portion may be provided below a via portion of any given metal layer of the BEOL portion 920. The trench portion of a metal layer may be configured for transferring signals and power along metal lines (also sometimes referred to as "trenches") extending in the x-y plane (e.g., in the x or y directions), while the via portion of a metal layer may be configured for transferring signals and power through metal vias extending in the z-direction, e.g., to any of the adjacent metal layers above or below. Accordingly, vias connect metal structures (e.g., metal lines or vias) from one metal layer to metal structures of an adjacent metal layer. While referred to as "metal" layers, various layers of the BEOL portion 920, e.g., layers M1-Mn shown in FIG. 9, may include certain patterns of conductive metals, e.g., copper (Cu) or aluminum (Al), or metal alloys, or more generally, patterns of an electrically conductive material, formed in an insulating medium such as an interlayer dielectric (ILD). The insulating medium may include any suitable ILD materials such as silicon oxide, silicon nitride, aluminum oxide, and/or silicon oxynitride. In various embodiments, any one or more of these layers may additionally include active devices (e.g., transistors, diodes) and/or passive devices (e.g., capacitors, resistors, inductors).

The IC device 900 may also include a backside 940. For example, the backside 940 may formed on the opposite side of a wafer from the front side 930. In various embodiments, the backside 940 may include any suitable elements to assist operation of the IC device 900. For example, the backside 940 may include various metal layers to deliver power to logic of the FEOL portion 910. In some embodiments, transistors or other circuit elements may be formed on the backside 940 of the IC device 900.

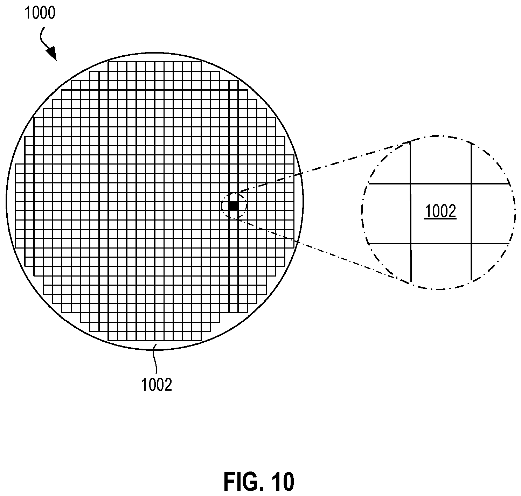

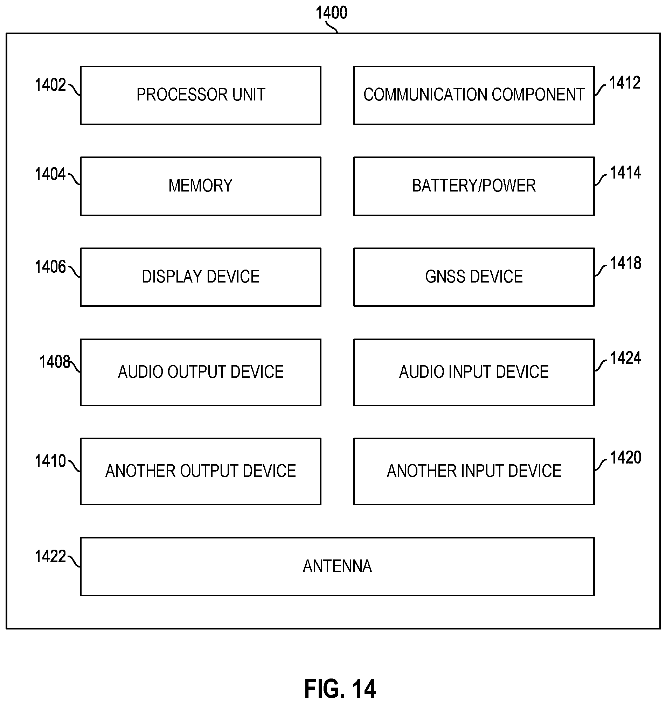

FIG. 10 is a top view of a wafer 1000 and dies 1002 wherein individual dies may include one or more transistors comprising a gallium enriched layer as described herein. The wafer 1000 may be composed of semiconductor material and may include one or more dies 1002 having integrated circuit structures formed on a surface of the wafer 1000. The individual dies 1002 may be a repeating unit of an integrated circuit product that includes any suitable integrated circuit. After the fabrication of the semiconductor product is complete, the wafer 1000 may undergo a singulation process in which the dies 1002 are separated from one another to provide discrete "chips" of the integrated circuit product. The die 1002 may include one or more transistors supporting circuitry to route electrical signals to the transistors, passive components (e.g., signal traces, resistors, capacitors, or inductors), and/or any other integrated circuit components. In some embodiments, the wafer 1000 or the die 1002 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1002. For example, a memory array formed by multiple memory devices may be formed on a same die 1002 as a processor unit (e.g., the processor unit 1402 of FIG. 14) or other logic that is configured to store information in the memory devices or execute instructions stored in the memory array. Various ones of the microelectronic assemblies disclosed herein may be manufactured using a die-to-wafer assembly technique in which some dies are attached to a wafer 1000 that include other dies, and the wafer 1000 is subsequently singulated.

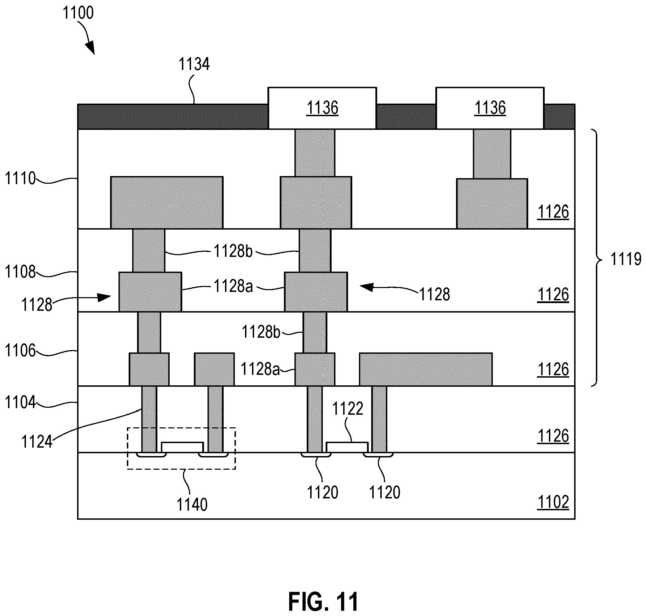

FIG. 11 is a cross-sectional side view of an integrated circuit device 1100 that may include one or more transistors comprising a gallium enriched layer as described herein. One or more of the integrated circuit devices 1100 may be included in one or more dies 1002 (FIG. 10). The integrated circuit device 1100 may be formed on a die substrate 1102 (e.g., the wafer 1000 of FIG. 10) and may be included in a die (e.g., the die 1002 of FIG. 10). The die substrate 1102 may be a semiconductor substrate composed of semiconductor material systems including, for example, n-type or p-type materials systems (or a combination of both). The die substrate 1102 may include, for example, a crystalline substrate formed using a bulk silicon or a silicon-on-insulator (SOI) substructure. In some embodiments, the die substrate 1102 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1102. Although a few examples of materials from which the die substrate 1102 may be formed are described here, any material that may serve as a foundation for an integrated circuit device 1100 may be used. The die substrate 1102 may be part of a singulated die (e.g., the dies 1002 of FIG. 10) or a wafer (e.g., the wafer 1000 of FIG. 10).

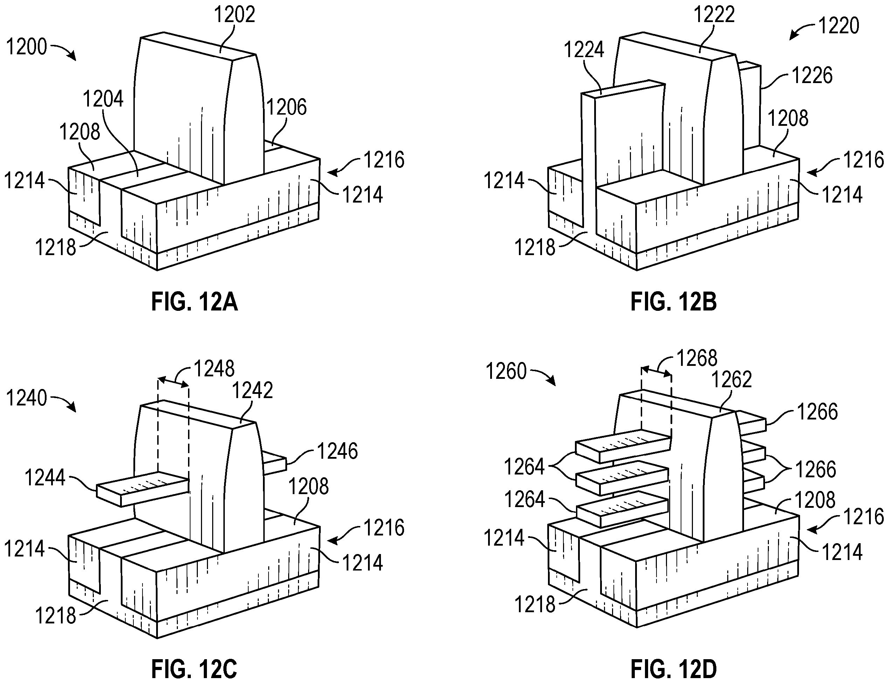

The integrated circuit device 1100 may include one or more device layers 1104 disposed on the die substrate 1102. The device layer 1104 may include features of one or more transistors 1140 (e.g., metal oxide semiconductor field-effect transistors (MOSFETs)) formed on the die substrate 1102. The transistors 1140 may include, for example, one or more source and/or drain (S/D) regions 1120, a gate 1122 to control current flow between the S/D regions 1120, and one or more S/D contacts 1124 to route electrical signals to/from the S/D regions 1120. The transistors 1140 may include additional features not depicted for the sake of clarity, such as device isolation regions, gate contacts, and the like. The transistors 1140 are not limited to the type and configuration depicted in FIG. 11 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon, nanosheet, or nanowire transistors. Examples of non-planar transistors will be described in connection with FIGs. 12A-12D.

A transistor 1140 may include a gate 1122 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1140 is to be a p-type metal oxide semiconductor (PMOS) or an n-type metal oxide semiconductor (NMOS) transistor. In some implementations, the gate electrode may consist of or comprise a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1140 along the source-channel-drain direction, the gate electrode may consist of or comprise a U-shaped structure that includes a bottom portion substantially parallel to the surface of the die substrate 1102 and two sidewall portions that are substantially perpendicular to the top surface of the die substrate 1102. In other embodiments, at least one of the metal layers that form the gate electrode may simply be a planar layer that is substantially parallel to the top surface of the die substrate 1102 and does not include sidewall portions substantially perpendicular to the top surface of the die substrate 1102. In other embodiments, the gate electrode may consist of or comprise a combination of U-shaped structures and planar, non-U-shaped structures. For example, the gate electrode may consist of or comprise one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1120 may be formed within the die substrate 1102 adjacent to the gate 1122 of individual transistors 1140. The S/D regions 1120 may be formed using an implantation/diffusion process or an etching/deposition process, for example. In the former process, dopants such as boron, aluminum, antimony, phosphorous, or arsenic may be ion-implanted into the die substrate 1102 to form the S/D regions 1120. An annealing process that activates the dopants and causes them to diffuse farther into the die substrate 1102 may follow the ion-implantation process. In the latter process, the die substrate 1102 may first be etched to form recesses at the locations of the S/D regions 1120. An epitaxial deposition process may then be carried out to fill the recesses with material that is used to fabricate the S/D regions 1120. In some implementations, the S/D regions 1120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1120 may be formed using one or more alternate semiconductor materials such as germanium or a group III-V material or alloy. In further embodiments, one or more layers of metal and/or metal alloys may be used to form the S/D regions 1120.

Electrical signals, such as power and/or input/output (I/O) signals, may be routed to and/or from the devices (e.g., transistors 1140) of the device layer 1104 through one or more interconnect layers disposed on the device layer 1104 (illustrated in FIG. 11 as interconnect layers 1106-1110). For example, electrically conductive features of the device layer 1104 (e.g., the gate 1122 and the S/D contacts 1124) may be electrically coupled with the interconnect structures 1128 of the interconnect layers 1106-1110. The one or more interconnect layers 1106-1110 may form a metallization stack (also referred to as an "ILD stack") 1119 of the integrated circuit device 1100.

The interconnect structures 1128 (e.g., lines) may be arranged within the interconnect layers 1106-1110 to route electrical signals according to a wide variety of designs; in particular, the arrangement is not limited to the particular configuration of interconnect structures 1128 depicted in FIG. 11. Although a particular number of interconnect layers 1106-1110 is depicted in FIG. 11, embodiments of the present disclosure include integrated circuit devices having more or fewer interconnect layers than depicted.

In some embodiments, the interconnect structures 1128 may include lines 1128a and/or vias 1128b filled with an electrically conductive material such as a metal. The lines 1128a may be arranged to route electrical signals in a direction of a plane that is substantially parallel with a surface of the die substrate 1102 upon which the device layer 1104 is formed. For example, the lines 1128a may route electrical signals in a direction in and out of the page and/or in a direction across the page. The vias 1128b may be arranged to route electrical signals in a direction of a plane that is substantially perpendicular to the surface of the die substrate 1102 upon which the device layer 1104 is formed. In some embodiments, the vias 1128b may electrically couple lines 1128a of different interconnect layers 1106-1110 together.

The interconnect layers 1106-1110 may include a dielectric material 1126 disposed between the interconnect structures 1128, as shown in FIG. 11. In some embodiments, dielectric material 1126 disposed between the interconnect structures 1128 in different ones of the interconnect layers 1106-1110 may have different compositions; in other embodiments, the composition of the dielectric material 1126 between different interconnect layers 1106-1110 may be the same. The device layer 1104 may include a dielectric material 1126 disposed between the transistors 1140 and a bottom layer of the metallization stack as well. The dielectric material 1126 included in the device layer 1104 may have a different composition than the dielectric material 1126 included in the interconnect layers 1106-1110; in other embodiments, the composition of the dielectric material 1126 in the device layer 1104 may be the same as a dielectric material 1126 included in any one of the interconnect layers 1106-1110.

A first interconnect layer 1106 (referred to as Metal 1 or "M1") may be formed directly on the device layer 1104. In some embodiments, the first interconnect layer 1106 may include lines 1128a and/or vias 1128b, as shown. The lines 1128a of the first interconnect layer 1106 may be coupled with contacts (e.g., the S/D contacts 1124) of the device layer 1104. The vias 1128b of the first interconnect layer 1106 may be coupled with the lines 1128a of a second interconnect layer 1108.

The second interconnect layer 1108 (referred to as Metal 2 or "M2") may be formed directly on the first interconnect layer 1106. In some embodiments, the second interconnect layer 1108 may include via 1128b to couple the interconnect structures 1128 of the second interconnect layer 1108 with the lines 1128a of a third interconnect layer 1110. Although the lines 1128a and the vias 1128b are structurally delineated with a line within individual interconnect layers for the sake of clarity, the lines 1128a and the vias 1128b may be structurally and/or materially contiguous (e.g., simultaneously filled during a dual-damascene process) in some embodiments.

The third interconnect layer 1110 (referred to as Metal 11 or "M3") (and additional interconnect layers, as desired) may be formed in succession on the second interconnect layer 1108 according to similar techniques and configurations described in connection with the second interconnect layer 1108 or the first interconnect layer 1106. In some embodiments, the interconnect layers that are "higher up" in the metallization stack 1119 in the integrated circuit device 1100 (e.g., farther away from the device layer 1104) may be thicker that the interconnect layers that are lower in the metallization stack 1119, with lines 1128a and vias 1128b in the higher interconnect layers being thicker than those in the lower interconnect layers.

The integrated circuit device 1100 may include a solder resist material 1134 (e.g., polyimide or similar material) and one or more conductive contacts 1136 formed on the interconnect layers 1106-1110. In FIG. 11, the conductive contacts 1136 are illustrated as taking the form of bond pads. The conductive contacts 1136 may be electrically coupled with the interconnect structures 1128 and configured to route the electrical signals of the transistor(s) 1140 to external devices. For example, solder bonds may be formed on the one or more conductive contacts 1136 to mechanically and/or electrically couple an integrated circuit die including the integrated circuit device 1100 with another component (e.g., a printed circuit board). The integrated circuit device 1100 may include additional or alternate structures to route the electrical signals from the interconnect layers 1106-1110; for example, the conductive contacts 1136 may include other analogous features (e.g., posts) that route the electrical signals to external components.

In some embodiments in which the integrated circuit device 1100 is a double-sided die, the integrated circuit device 1100 may include another metallization stack (not shown) on the opposite side of the device layer(s) 1104. This metallization stack may include multiple interconnect layers as discussed above with reference to the interconnect layers 1106-1110, to provide conductive pathways (e.g., including conductive lines and vias) between the device layer(s) 1104 and additional conductive contacts (not shown) on the opposite side of the integrated circuit device 1100 from the conductive contacts 1136.

In other embodiments in which the integrated circuit device 1100 is a double-sided die, the integrated circuit device 1100 may include one or more through silicon vias (TSVs) through the die substrate 1102; these TSVs may make contact with the device layer(s) 1104, and may provide conductive pathways between the device layer(s) 1104 and additional conductive contacts (not shown) on the opposite side of the integrated circuit device 1100 from the conductive contacts 1136. In some embodiments, TSVs extending through the substrate can be used for routing power and ground signals from conductive contacts on the opposite side of the integrated circuit device 1100 from the conductive contacts 1136 to the transistors 1140 and any other components integrated into the integrated circuit device (e.g., die) 1100, and the metallization stack 1119 can be used to route I/O signals from the conductive contacts 1136 to transistors 1140 and any other components integrated into the integrated circuit device (e.g., die) 1100.

Multiple integrated circuit devices 1100 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adj acent integrated circuit dies in the stack. In some embodiments, the conductive contacts can be fine-pitch solder bumps (microbumps).

FIGS. 12A-12D are simplified perspective views of example planar, FinFET, gate-all-around, and stacked gate-all-around transistors. The transistors illustrated in FIGS. 12A-12D are formed on a substrate 1216 having a surface 1208. Isolation regions 1214 separate the source and drain regions of the transistors from other transistors and from a bulk region 1218 of the substrate 1216.

FIG. 12A is a perspective view of an example planar transistor 1200 comprising a gate 1202 that controls current flow between a source region 1204 and a drain region 1206. The transistor 1200 is planar in that the source region 1204 and the drain region 1206 are planar with respect to the substrate surface 1208.

FIG. 12B is a perspective view of an example FinFET transistor 1220 comprising a gate 1222 that controls current flow between a source region 1224 and a drain region 1226. The transistor 1220 is non-planar in that the source region 1224 and the drain region 1226 comprise "fins" that extend upwards from the substrate surface 1228. As the gate 1222 encompasses three sides of the semiconductor fin that extends from the source region 1224 to the drain region 1226, the transistor 1220 can be considered a tri-gate transistor. FIG. 12B illustrates one S/D fin extending through the gate 1222, but multiple S/D fins can extend through the gate of a FinFET transistor.

FIG. 12C is a perspective view of a gate-all-around (GAA) transistor 1240 comprising a gate 1242 that controls current flow between a source region 1244 and a drain region 1246. The transistor 1240 is non-planar in that the source region 1244 and the drain region 1246 are elevated from the substrate surface 1228.

FIG. 12D is a perspective view of a GAA transistor 1260 comprising a gate 1262 that controls current flow between multiple elevated source regions 1264 and multiple elevated drain regions 1266. The transistor 1260 is a stacked GAA transistor as the gate controls the flow of current between multiple elevated S/D regions stacked on top of each other. The transistors 1240 and 1260 are considered gate-all-around transistors as the gates encompass all sides of the semiconductor portions that extends from the source regions to the drain regions. The transistors 1240 and 1260 can alternatively be referred to as nanowire, nanosheet, or nanoribbon transistors depending on the width (e.g., widths 1248 and 1268 of transistors 1240 and 1260, respectively) of the semiconductor portions extending through the gate.

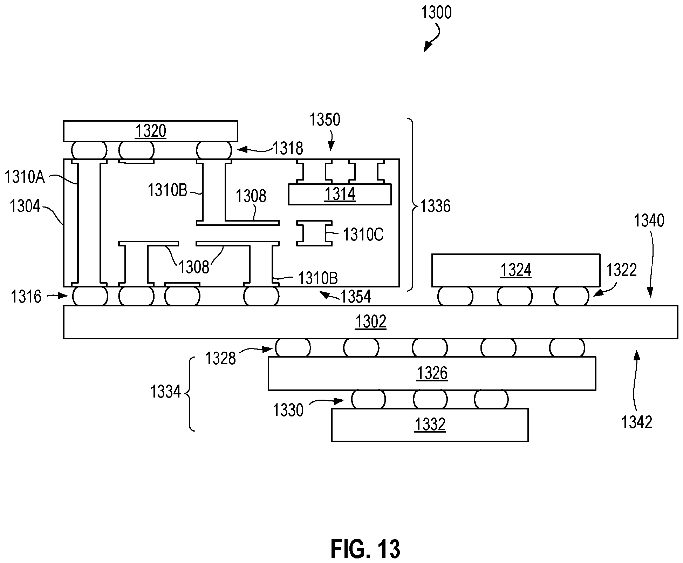

FIG. 13 is a cross-sectional side view of an integrated circuit device assembly 1300 that may include one or more transistors comprising a gallium enriched layer as described herein. The integrated circuit device assembly 1300 includes a number of components disposed on a circuit board 1302 (which may be a motherboard, system board, mainboard, etc.). The integrated circuit device assembly 1300 includes components disposed on a first face 1340 of the circuit board 1302 and an opposing second face 1342 of the circuit board 1302; generally, components may be disposed on one or both faces 1340 and 1342.

In some embodiments, the circuit board 1302 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1302. In other embodiments, the circuit board 1302 may be a non-PCB substrate. The integrated circuit device assembly 1300 illustrated in FIG. 13 includes a package-on-interposer structure 1336 coupled to the first face 1340 of the circuit board 1302 by coupling components 1316. The coupling components 1316 may electrically and mechanically couple the package-on-interposer structure 1336 to the circuit board 1302, and may include solder balls (as shown in FIG. 13), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1336 may include an integrated circuit component 1320 coupled to an interposer 1304 by coupling components 1318. The coupling components 1318 may take any suitable form for the application, such as the forms discussed above with reference to the coupling components 1316. Although a single integrated circuit component 1320 is shown in FIG. 13, multiple integrated circuit components may be coupled to the interposer 1304; indeed, additional interposers may be coupled to the interposer 1304. The interposer 1304 may provide an intervening substrate used to bridge the circuit board 1302 and the integrated circuit component 1320.

The integrated circuit component 1320 may be a packaged or unpackaged integrated circuit product that includes one or more integrated circuit dies (e.g., the die 1002 of FIG.2, the integrated circuit device 1100 of FIG. 11) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1320, a single monolithic integrated circuit die comprises solder bumps attached to contacts on the die. The solder bumps allow the die to be directly attached to the interposer 1304. The integrated circuit component 1320 can comprise one or more computing system components, such as one or more processor units (e.g., system-on-α-chip (SoC), processor core, graphics processor unit (GPU), accelerator, chipset processor), I/O controller, memory, or network interface controller. In some embodiments, the integrated circuit component 1320 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1320 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1320 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1304 may spread connections to a wider pitch or reroute a connection to a different connection. For example, the interposer 1304 may couple the integrated circuit component 1320 to a set of ball grid array (BGA) conductive contacts of the coupling components 1316 for coupling to the circuit board 1302. In the embodiment illustrated in FIG. 13, the integrated circuit component 1320 and the circuit board 1302 are attached to opposing sides of the interposer 1304; in other embodiments, the integrated circuit component 1320 and the circuit board 1302 may be attached to a same side of the interposer 1304. In some embodiments, three or more components may be interconnected by way of the interposer 1304.

In some embodiments, the interposer 1304 may be formed as a PCB, including multiple metal layers separated from one another by layers of dielectric material and interconnected by electrically conductive vias. In some embodiments, the interposer 1304 may be formed of an epoxy resin, a fiberglass-reinforced epoxy resin, an epoxy resin with inorganic fillers, a ceramic material, or a polymer material such as polyimide. In some embodiments, the interposer 1304 may be formed of alternate rigid or flexible materials that may include the same materials described above for use in a semiconductor substrate, such as silicon, germanium, and other group III-V and group IV materials. The interposer 1304 may include metal interconnects 1308 and vias 1310, including but not limited to through hole vias 1310-1 (that extend from a first face 1350 of the interposer 1304 to a second face 1354 of the interposer 1304), blind vias 1310-2 (that extend from the first or second faces 1350 or 1354 of the interposer 1304 to an internal metal layer), and buried vias 1310-3 (that connect internal metal layers).

In some embodiments, the interposer 1304 can comprise a silicon interposer. Through silicon vias (TSV) extending through the silicon interposer can connect connections on a first face of a silicon interposer to an opposing second face of the silicon interposer. In some embodiments, an interposer 1304 comprising a silicon interposer can further comprise one or more routing layers to route connections on a first face of the interposer 1304 to an opposing second face of the interposer 1304.

The interposer 1304 may further include embedded devices 1314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1304. The package-on-interposer structure 1336 may take the form of any of the package-on-interposer structures known in the art.

The integrated circuit device assembly 1300 may include an integrated circuit component 1324 coupled to the first face 1340 of the circuit board 1302 by coupling components 1322. The coupling components 1322 may take the form of any of the embodiments discussed above with reference to the coupling components 1316, and the integrated circuit component 1324 may take the form of any of the embodiments discussed above with reference to the integrated circuit component 1320.

The integrated circuit device assembly 1300 illustrated in FIG. 13 includes a package-on-package structure 1334 coupled to the second face 1342 of the circuit board 1302 by coupling components 1328. The package-on-package structure 1334 may include an integrated circuit component 1326 and an integrated circuit component 1332 coupled together by coupling components 1330 such that the integrated circuit component 1326 is disposed between the circuit board 1302 and the integrated circuit component 1332. The coupling components 1328 and 1330 may take the form of any of the embodiments of the coupling components 1316 discussed above, and the integrated circuit components 1326 and 1332 may take the form of any of the embodiments of the integrated circuit component 1320 discussed above. The package-on-package structure 1334 may be configured in accordance with any of the package-on-package structures known in the art.

FIG. 14 is a block diagram of an example electrical device 1400 that may include one or more transistors comprising a gallium enriched layer as described herein. For example, any suitable ones of the components of the electrical device 1400 may include one or more of the integrated circuit dies 1002, integrated circuit devices 1100, integrated circuit device assemblies 1300, integrated circuit components 1320, or other components disclosed herein. A number of components are illustrated in FIG. 14 as included in the electrical device 1400, but any one or more of these components may be omitted or duplicated, as suitable for the application. In some embodiments, some or all of the components included in the electrical device 1400 may be attached to one or more motherboards mainboards, or system boards. In some embodiments, one or more of these components are fabricated onto a single system-on-a-chip (SoC) die.

Additionally, in various embodiments, the electrical device 1400 may not include one or more of the components illustrated in FIG. 14, but the electrical device 1400 may include interface circuitry for coupling to the one or more components. For example, the electrical device 1400 may not include a display device 1406, but may include display device interface circuitry (e.g., a connector and driver circuitry) to which a display device 1406 may be coupled. In another set of examples, the electrical device 1400 may not include an audio input device 1424 or an audio output device 1408, but may include audio input or output device interface circuitry (e.g., connectors and supporting circuitry) to which an audio input device 1424 or audio output device 1408 may be coupled.

The electrical device 1400 may include one or more processor units 1402 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1402 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1400 may include a memory 1404, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1404 may include memory that is located on the same integrated circuit die as the processor unit 1402. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1400 can comprise one or more processor units 1402 that are heterogeneous or asymmetric to another processor unit 1402 in the electrical device 1400. There can be a variety of differences between the processing units 1402 in a system in terms of a spectrum of metrics of merit including architectural, microarchitectural, thermal, power consumption characteristics, and the like. These differences can effectively manifest themselves as asymmetry and heterogeneity among the processor units 1402 in the electrical device 1400.

In some embodiments, the electrical device 1400 may include a communication component 1412 (e.g., one or more communication components). For example, the communication component 1412 can manage wireless communications for the transfer of data to and from the electrical device 1400. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1412 may operate in accordance with other wireless protocols in other embodiments. The electrical device 1400 may include an antenna 1422 to facilitate wireless communications and/or to receive other wireless communications (such as amplitude modulation (AM) or frequency modulation (FM) radio transmissions).

In some embodiments, the communication component 1412 may manage wired communications, such as electrical, optical, or any other suitable communication protocols (e.g., IEEE 802.3 Ethernet standards). As noted above, the communication component 1412 may include multiple communication components. For instance, a first communication component 1412 may be dedicated to shorter-range wireless communications such as Wi-Fi or Bluetooth, and a second communication component 1412 may be dedicated to longer-range wireless communications such as global positioning system (GPS), EDGE, GPRS, CDMA, WiMAX, LTE, EV-DO, or others. In some embodiments, a first communication component 1412 may be dedicated to wireless communications, and a second communication component 1412 may be dedicated to wired communications.

The electrical device 1400 may include battery/power circuitry 1414. The battery/power circuitry 1414 may include one or more energy storage devices (e.g., batteries or capacitors) and/or circuitry for coupling components of the electrical device 1400 to an energy source separate from the electrical device 1400 (e.g., AC line power).

The electrical device 1400 may include a display device 1406 (or corresponding interface circuitry, as discussed above). The display device 1406 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1400 may include an audio output device 1408 (or corresponding interface circuitry, as discussed above). The audio output device 1408 may include any embedded or wired or wirelessly connected external device that generates an audible indicator, such speakers, headsets, or earbuds.

The electrical device 1400 may include an audio input device 1424 (or corresponding interface circuitry, as discussed above). The audio input device 1424 may include any embedded or wired or wirelessly connected device that generates a signal representative of a sound, such as microphones, microphone arrays, or digital instruments (e.g., instruments having a musical instrument digital interface (MIDI) output). The electrical device 1400 may include a Global Navigation Satellite System (GNSS) device 1418 (or corresponding interface circuitry, as discussed above), such as a Global Positioning System (GPS) device. The GNSS device 1418 may be in communication with a satellite-based system and may determine a geolocation of the electrical device 1400 based on information received from one or more GNSS satellites, as known in the art.

The electrical device 1400 may include another output device 1410 (or corresponding interface circuitry, as discussed above). Examples of the other output device 1410 may include an audio codec, a video codec, a printer, a wired or wireless transmitter for providing information to other devices, or an additional storage device.

The electrical device 1400 may include another input device 1420 (or corresponding interface circuitry, as discussed above). Examples of the other input device 1420 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1400 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1400 may be any other electronic device that processes data. In some embodiments, the electrical device 1400 may comprise multiple discrete physical components. Given the range of devices that the electrical device 1400 can be manifested as in various embodiments, in some embodiments, the electrical device 1400 can be referred to as a computing device or a computing system.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

It will also be understood that, although the terms "first," "second," and so forth may be used herein to describe various elements, these elements should not be limited by these terms. These terms are only used to distinguish one element from another, and are not intended to imply that the objects so described must be in a given sequence, either temporally, spatially, in ranking or in any other manner. For example, a first contact could be termed a second contact, and, similarly, a second contact could be termed a first contact, without departing from the scope of the present example embodiments. The first contact and the second contact are both contacts, but they are not the same contact.

As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. For example, the phrase "A and/or B" means (A), (B), or (A and B), while the phrase "A, B, and/or C" means (A), (B), (C), (A and B), (A and C), (B and C), or (A, B, and C).

As used throughout this description, and in the claims, a list of items joined by the term "at least one of" or "one or more of" can mean any combination of the listed terms.

It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Furthermore, the terms "comprising," "including," "having," and the like, as used with respect to embodiments of the present disclosure, are synonymous.

The description may use the phrases "in an embodiment," "according to some embodiments," "in accordance with embodiments," or "in embodiments," which may each refer to one or more of the same or different embodiments.

As used herein, the term "module" refers to being part of, or including an ASIC, an electronic circuit, a system on a chip, a processor (shared, dedicated, or group), a solid state device, a memory (shared, dedicated, or group) that execute one or more software or firmware programs, a combinational logic circuit, and/or other suitable components that provide the described functionality.

As used herein, "electrically conductive" in some examples may refer to a property of a material having an electrical conductivity greater than or equal to 107 Siemens per meter (S/m) at 20 degrees Celsius. Examples of such materials include Cu, Ag, Al, Au, W, Zn and Ni.

The term "signal" may refer to at least one current signal, voltage signal, magnetic signal, or data/clock signal.

Throughout the specification, and in the claims, the term "connected" means a direct connection, such as electrical, mechanical, or magnetic connection between the elements that are connected, without any intermediary devices. The term "coupled" means a direct or indirect connection, such as a direct electrical, mechanical, or magnetic connection between the elements that are connected or an indirect connection, through one or more passive or active intermediary devices.

The description may use perspective-based descriptions such as top/bottom, in/out, over/under, and the like. Such descriptions are merely used to facilitate the discussion and are not intended to restrict the application of embodiments described herein to any particular orientation.

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer means that at least a part of the first material or layer is in direct physical contact with at least a part of that second material/layer. Similar distinctions are to be made in the context of component assemblies.

As used herein, "A is adjacent to B" means that at least part of A is in direct physical contact with at least a part of B.

As used herein, "A is proximate to B" may mean that A is adjacent to B or A is otherwise near to B.

Unless otherwise specified in the specific context of use, the term "predominantly" means more than 50%, or more than half. For example, a composition that is predominantly a first constituent means more than half of the composition (e.g., by volume) is the first constituent (e.g., >50 at. %). The term "primarily" means the most, or greatest, part. For example, a composition that is primarily a first constituent means the composition has more of the first constituent (e.g., by volume) than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

The terms "substantially," "close," "approximately," "near," and "about," generally refer to being within +/- 10% of a target value (unless specifically specified).

Unless otherwise specified in the explicit context of their use, the terms "substantially equal," "about equal" or "approximately equal" mean that there is no more than incidental variation between two things so described. In the art, such variation is typically no more than +/-10% of a predetermined target value.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements.

Although the figures may illustrate embodiments where structures are substantially aligned to Cartesian axes (e.g., device structures having substantially vertical sidewalls), positive and negative (re-entrant) sloped feature sidewalls often occur in practice. For example, manufacturing non-idealities may cause one or more structural features to have sloped sidewalls. Thus, attributes illustrated are idealized merely for the sake of clearly describing salient features. It is to be understood that schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Example 1 includes an apparatus, comprising a substrate comprising silicon; a first layer of a source or drain region of a p-type transistor, the first layer positioned above the substrate, the first layer comprising boron, silicon and germanium; a second layer coupled to the source or drain region, the second layer comprising a metal contact for the source or drain region; and a third layer positioned between the first layer and the second layer, the third layer comprising at least one monolayer comprising gallium, wherein the third layer is adjacent to the first layer.

Example 2 includes the subject matter of Example 1, and wherein the first layer comprises epitaxially grown boron doped silicon germanium, and the third layer comprises epitaxially grown boron doped silicon germanium with a higher concentration of germanium than the first layer.

Example 3 includes the subject matter of Examples 1-2, wherein the third layer is between 10-20 nanometers thick.

Example 4 includes the subject matter of any of Examples 1-3, further comprising a fourth layer between the second layer and the third layer, the fourth layer comprising at least one of titanium, nickel, or platinum.

Example 5 includes the subject matter of any of Examples 1-4, wherein the second layer comprises at least one of cobalt or tungsten.

Example 6 includes the subject matter of any of Examples 1-5, wherein a concentration of gallium in a top two monolayers of the third layer is within a range of 5E19 to 5E20 atoms/cm³.

Example 7 includes the subject matter of any of Examples 1-6, wherein the first layer comprises both B-11 and B-10 isotopes of boron.

Example 8 includes the subject matter of any of Examples 1-7, wherein the apparatus is an integrated circuit component.

Example 9 includes the subject matter of any of Examples 1-8, wherein the apparatus further comprises a printed circuit board; and a first integrated circuit component attached to the printed circuit board, the first integrated circuit component comprising the substrate, the first layer, the second layer, and the third layer.

Example 10 includes the subject matter of Example 9, wherein the apparatus further comprises one or more second integrated circuit components attached to the printed circuit board.

Example 11 includes an apparatus, comprising a substrate comprising silicon; a first layer positioned adjacent to the substrate, the first layer comprising boron, silicon and germanium; a second layer positioned adjacent to the first layer, the second layer comprising gallium; and a third layer positioned adjacent to the second layer, the third layer comprising a metal.

Example 12 includes the subject matter of Example 11, and wherein a concentration of gallium in the second layer is within a range of 5E19 to 5E20 atoms/cm3.

Example 13 includes the subject matter of any of Examples 11-12, wherein the first layer comprises epitaxially grown boron doped silicon germanium and the second layer comprises epitaxially grown boron doped silicon germanium with a higher concentration of germanium than the first layer.

Example 14 includes the subject matter of any of Examples 11-13, The apparatus of claim 11, wherein an atomic percentage of gallium in a portion of the second layer below a top two monolayers of the second layer is less than five percent.

Example 15 includes the subject matter of any of Examples 11-14, wherein the third layer comprises at least one of titanium, nickel, platinum, cobalt, or tungsten.

Example 16 includes the subject matter of any of Examples 11-15, wherein the third layer comprises at least one of titanium, nickel, or platinum.

Example 17 includes the subject matter of any of Examples 11-16, further comprising a fourth layer adjacent to the third layer, wherein the third layer comprises at least one of cobalt or tungsten.

Example 18 includes the subject matter of any of Examples 11-17, wherein the first layer comprises both B-11 and B-10 isotopes of boron.

Example 19 includes the subject matter of any of Examples 11-18, wherein the apparatus is an integrated circuit component.

Example 20 includes the subject matter of any of Examples 11-19, wherein the apparatus further comprises a printed circuit board; and a first integrated circuit component attached to the printed circuit board, the first integrated circuit component comprising the substrate, the first layer, the second layer, and the third layer.

Example 21 includes the subject matter of any of Examples 11-20, and wherein the apparatus further comprises one or more second integrated circuit components attached to the printed circuit board.

Example 22 includes a method, comprising forming a first layer comprising boron, silicon, and germanium, the first layer positioned above a substrate; forming a second layer positioned adjacent to the first layer, the second layer comprising gallium; and forming a third layer comprising metal, the third layer located on the second layer.

Example 23 includes the subject matter of Example 22, and wherein forming the second layer comprises applying triethyl gallium on the first layer.

Example 24 includes the subject matter of any of Examples 22-23, wherein forming the second layer comprises applying trimethyl gallium to the first layer.

Example 25 includes the subject matter of any of Examples 22-24, wherein forming the second layer comprises applying a precursor comprising gallium to the first layer at a temperature of between 375 and 500 degrees Celsius.

Example 26 includes the subject matter of any of Examples 22-25, wherein a concentration of gallium in a portion of the second layer is within a range of 5E19 to 5E20 atoms/cm3.

Example 27 includes the subject matter of any of Examples 22-26, wherein the first layer comprises epitaxially grown boron doped silicon germanium.

Example 28 includes the subject matter of any of Examples 22-27, wherein gallium is substantially present only in two adjacent monolayers of the second layer.

Example 29 includes the subject matter of any of Examples 22-28, further comprising forming a fourth layer on the third layer, the fourth layer comprising a second metal.

Example 30 includes the subject matter of any of Examples 22-29, and wherein the second metal comprises at least one of cobalt or tungsten.

Example 31 includes the subject matter of any of Examples 22-30, wherein the third layer comprises at least one of titanium, nickel, or platinum.

Example 32 includes the subject matter of any of Examples 22-31, wherein the first layer comprises both B-11 and B-10 isotopes of boron.

The foregoing description, for the purpose of explanation, has been described with reference to specific example embodiments. However, the illustrative discussions above are not intended to be exhaustive or to limit the possible example embodiments to the precise forms disclosed. Many modifications and variations are possible in view of the above teachings. The example embodiments were chosen and described in order to best explain the principles involved and their practical applications, to thereby enable others skilled in the art to best utilize the various example embodiments with various modifications as are suited to the particular use contemplated.

## Claims

1. An apparatus, comprising:
a substrate comprising silicon;
a first layer of a source or drain region of a p-type transistor, the first layer positioned above the substrate, the first layer comprising boron, silicon and germanium;
a second layer coupled to the source or drain region, the second layer comprising a metal contact for the source or drain region; and
a third layer positioned between the first layer and the second layer, the third layer comprising at least one monolayer comprising gallium, wherein the third layer is adjacent to the first layer.

2. The apparatus of claim 1, wherein the first layer comprises epitaxially grown boron doped silicon germanium, and the third layer comprises epitaxially grown boron doped silicon germanium with a higher concentration of germanium than the first layer.

3. The apparatus of any of claims 1-2, wherein the third layer is between 10-20 nanometers thick.

4. The apparatus of any of claims 1-3, further comprising a fourth layer between the second layer and the third layer, the fourth layer comprising at least one of titanium, nickel, or platinum.

5. The apparatus of any of claims 1-4, wherein the second layer comprises at least one of cobalt or tungsten.

6. The apparatus of any of claims 1-5, wherein a concentration of gallium in a top two monolayers of the third layer is within a range of 5E19 to 5E20 atoms/cm³.

7. The apparatus of any of claims 1-6, wherein the first layer comprises both B-11 and B-10 isotopes of boron.

8. The apparatus of any of claims 1-7, wherein the apparatus is an integrated circuit component.

9. The apparatus of any of claims 1-8, wherein the apparatus further comprises:
a printed circuit board; and
a first integrated circuit component attached to the printed circuit board, the first integrated circuit component comprising the substrate, the first layer, the second layer, and the third layer.

10. The apparatus of claim 9, wherein the apparatus further comprises one or more second integrated circuit components attached to the printed circuit board.

11. A method, comprising:
forming a first layer comprising boron, silicon, and germanium, the first layer positioned above a substrate;
forming a second layer positioned adjacent to the first layer, the second layer comprising gallium; and
forming a third layer comprising metal, the third layer located on the second layer.

12. The method of claim 11, wherein forming the second layer comprises applying triethyl gallium on the first layer.

13. The method of any of claims 11-12, wherein forming the second layer comprises applying trimethyl gallium to the first layer.

14. The method of any of claims 11-13, wherein forming the second layer comprises applying a precursor comprising gallium to the first layer at a temperature of between 375 and 500 degrees Celsius.

15. The method of any of claims 11-14, wherein a concentration of gallium in a portion of the second layer is within a range of 5E19 to 5E20 atoms/cm³.
